# EUROPEAN PATENT SPECIFICATION

(11) **EP 4 484 521 B1**
(45) Date of publication and mention of the grant of the patent: **03.09.2025**
(21) Application number: 24160324.0
(22) Date of filing: 28.02.2024
(51) Int. Cl.: C09K 11/02, C09K 11/65

(54) **INSULATION LIGHT-CONVERSION FILM FOR PHOTOVOLTAIC ASSEMBLY AND PREPARATION METHOD THEREOF AND PHOTOVOLTAIC ASSEMBLY**
ISOLATIONSLICHTUMWANDLUNGSFOLIE FÜR FOTOVOLTAISCHE ANORDNUNG UND HERSTELLUNGSVERFAHREN DAFÜR UND FOTOVOLTAISCHE ANORDNUNG
FILM DE CONVERSION DE LUMIÈRE D'ISOLATION POUR ENSEMBLE PHOTOVOLTAÏQUE ET SON PROCÉDÉ DE PRÉPARATION ET ENSEMBLE PHOTOVOLTAÏQUE

(30) Priority: 25.06.2023 CN 202310744701
(43) Date of publication of application: 01.01.2025
(73) Proprietor: Suzhou Yisheng Optical Material Co., Ltd., Suzhou Jiangsu (CN)
(72) Inventor: Ju, Junjie, Suzhou (CN); Pan, Jun, Suzhou (CN); Yu, Minghua, Suzhou (CN); Meng, Xue, Suzhou (CN)
(74) Representative: Sun, Yanan

(56) References cited:
- CN-A- 106 098 952
- CN-A- 109 504 368
- CN-A- 114 685 907
- CN-B- 110 643 181

## Description

### CROSS REFERENCE TO RELATED APPLICATIONS

This application is based upon and claims foreign priority to Chinese Patent Application No. 202310744701.5, filed on June 25, 2023.

### TECHNIC FIELD

The present disclosure belongs to the technical field of encapsulating adhesive films and in particular relates to an insulation light-conversion film for a photovoltaic assembly and a preparation method thereof and a photovoltaic assembly.

### BACKGROUND

Solar spectrum is a continuous spectrum of different wavelengths, which consists of ultraviolet ray, visible light and infrared ray, where the ultraviolet ray and the infrared ray are invisible light. Generally, the solar cells have good response to medium-wavelength light (for example, blue light, green light and red light).

The ultraviolet ray has a low generation efficiency and can bring a severe damage to the photovoltaic assemblies, for example, the problems such as ultraviolet photolysis of backplates, EVA decolorization, ultraviolet photolysis of organic batteries (organic batteries, dye-sensitized batteries, and perovskite batteries), light induced degradation and light and elevated temperature induced degradation of crystalline silicon batteries are all resulted from light irradiation, severely affecting the power generation efficiency and assembly reliability. Basically, along with increase of the injection amount of the ultraviolet ray, the battery indexes almost drop linearly, and especially the open-circuit voltage drops most severely.

Therefore, it is extremely significant to convert ultraviolet light into visible light, which can not only improve the power generation efficiency but also prolong the service life of the assemblies.

### SUMMARY

The present disclosure provides an insulation light-conversion film for a photovoltaic assembly and a preparation method thereof and a photovoltaic assembly, so as to solve the problem of failure to apply a high conductivity of carbon-based quantum dots to encapsulation adhesive films.

In order to solve the above technical problem, the present disclosure provides an insulation light-conversion film for a photovoltaic assembly, which includes:
thermoplastic elastomer granules, siloxane-coated carbon quantum dots, a crosslinking agent, a co-crosslinking agent, a photostabilizer, an antioxidant, where the weight ratio of the above substances is as follows:
the thermoplastic elastomer granules: 100 parts;
the siloxane-coated carbon quantum dots: 1 to 5 parts;
the crosslinking agent: 0.2 to 2 parts;
the co-crosslinking agent: 0.2 to 0.5 parts;
the photostabilizer: 0.01 to 0.2 parts;
the antioxidant: 0.02 to 0.3 parts.

The summary of the present disclosure aims to provide brief descriptions for the subjects of the specification. Thus, it should be understood that the above features are only illustrative.

Other features, aspects and advantages of the subjects of the present disclosure will become apparent by way of the specific embodiments, drawings and claims.

### BRIEF DESCRIPTION OF THE DRAWINGS

In order to more clearly describe the technical solutions in the embodiments of the present disclosure or in the prior arts, the drawings required for descriptions of the specific embodiments or the prior arts will be briefly introduced. Apparently, the drawings described hereunder are only some embodiments of the present disclosure.
FIG. 1 is a morphological change diagram of carbon quantum dots after and before being coated according to the present disclosure.
FIG. 2 is an XRD diagram of carbon quantum dots and siloxane-coated carbon quantum dots according to the present disclosure.
FIG. 3 is a spectrum diagram of fluorescence emission of different adhesive films according to the present disclosure.

### DETAILED DESCRIPTION OF THE EMBODIMENTS

In order to make the object, technical solutions and advantages of the embodiments of the present disclosure clearer, the technical solutions of the present disclosure will be fully and clearly described in combination with drawings.

The present disclosure provides a preparation method of an insulation light-conversion film for a photovoltaic assembly, which includes the following steps: at step S1, by co-hydrolytic condensation of silicate ester and a silane coupling agent, performing insulation coating on carbon quantum dots to obtain siloxane-coated carbon quantum dots; at step S2, mixing the siloxane-coated carbon quantum dots, thermoplastic elastomer granules and aids uniformly to obtain a pre-prepared material; at step S3, preparing the pre-prepared material by film casting method into an insulation light-conversion film for the photovoltaic assembly; where the co-hydrolytic condensation includes the following steps: dissolving silicate ester and the silane coupling agent in an aqueous solution of an alcohol, and then adding carbon quantum dots and a catalyst and then stirring for 2 to 8 hours; performing centrifugation, washing and drying to obtain the siloxane-coated carbon quantum dots for later use; the thermoplastic elastomer granules are one of POE or EVA; the aids include a crosslinking agent, a co-crssolinking agent, a photostabilizer, and an antioxidant.

In one embodiment, in the co-hydrolytic condensation, the stirring manner is a mechanical stirring at a speed of 500 to 800rpm for a time of 2 to 8 hours; the centrifugation speed is 5000 to 10000rpm; the washing manner is alternately washing several times, preferably three times, with ethanol and water; the drying manner is vacuum drying at a drying temperature of 60 to 80°C. The co-hydrolytic condensation used herein is environment-friendly and simplifies the preparation method and thus favors industrialized production.

In one embodiment, specifically, the carbon quantum dots are one of or a mixture of carbon nanotube quantum dots, graphene quantum dots, nano-diamond quantum dots and fluorescent carbon particle quantum dots. Preferably, the carbon quantum dots are one of carboxyl-modified carbon quantum dots (CQDs-COOH), animated carbon quantum dots (CQDs-NH2) and hydroxylated carbon quantum dots (CQDs-OH). The used carbon quantum dots come from various sources and are inexpensive. Further, they are modified by active groups to facilitate post-treatments such as coating and modification and the like.

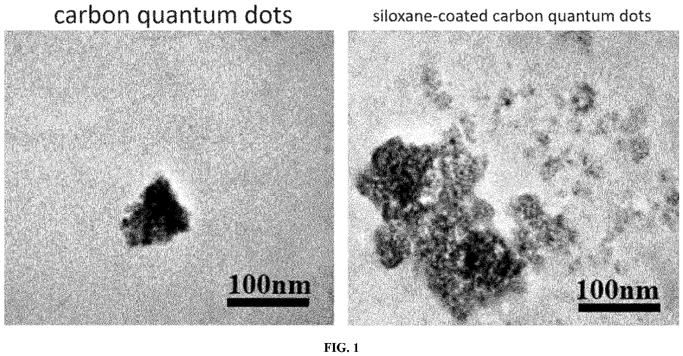

As shown in FIG. 1, after siloxane is coated on the carbon quantum dots, a uniform coating effect is formed on an outer surface of the carbon quantum dots. The carbon quantum dots can generate fluorescent effect under the excitation of ultraviolet light and convert this part of ultraviolet light into visible light. Furthermore, an amount of ultraviolet ray entering the assembly can be reduced effectively and a damage resulting from the ultraviolet ray can also be reduced. The siloxane coating can improve the dispersion effect of the carbon quantum dots and increase the conversion efficiency of the ultraviolet ray while ensuring the insulation and safety of the adhesive film. More importantly, after siloxane is coated on the carbon quantum dots, silicon oxygen bonds are present in the coating layer and can serve as a silane coupling agent, and thus there is no need to add the silane coupling agent again into the formula.

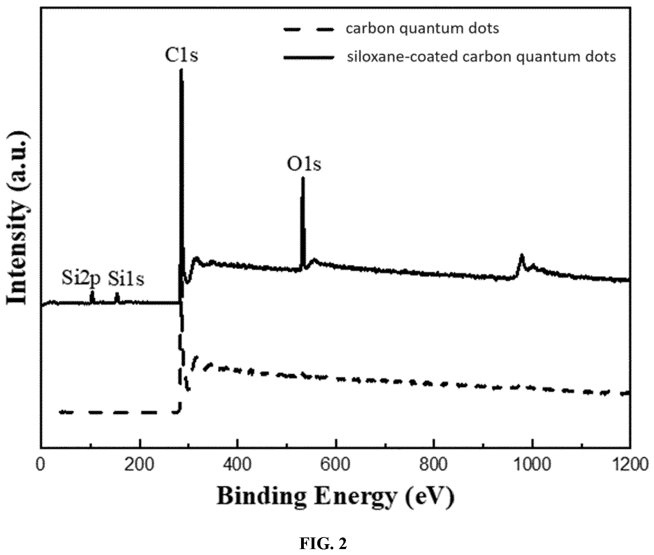

As shown in FIG. 2, the dotted line is an XRD diagram of the carbon quantum dots and the solid line is the siloxane-coated carbon quantum dots and can clearly represent siloxane has been coated on the carbon quantum dots.

In one embodiment, specifically, the silicate ester is any one of silicon tetraacetate, tetrakis(2-ethylhexyl) ester, tetraisopropyl orthosilicate, and tetramethyl orthosilicate.

In one embodiment, specifically, the silane coupling agent is any one ofKH550, KH560, KH570, KH792 and DL602.

In one embodiment, specifically, the alcohol is one of or a mixture of methanol, ethanol, propanol, isopropanol and n-butanol. Preferably, the weight ratio of the alcohol to water is 9:1, 8:2, 7:3 and 6:4.

In one embodiment, specifically, the catalyst is any one of ammonia water, formic acid, acetic acid, hydrochloric acid and ammonium chloride.

In one embodiment, specifically, the weight ratio of the silicate ester, the silane coupling agent, the catalyst, the alcohol, water and the carbon quantum dots is: the carbon quantum dots 1 to 5 parts; the silicate ester 1 to 10 parts; the silane coupling agent 1 to 10 parts; the catalyst 0.1 to 1 part; the alcohol 60 to 90 parts; and water 10 to 40 parts.

In one embodiment, specifically, the weight ratio of the thermoplastic elastomer granules, the siloxane-coated carbon quantum dots, the crosslinking agent, the co-crosslinking agent, the photostabilizer and the antioxidant is: the thermoplastic elastomer granules 100 parts; the siloxane-coated carbon quantum dots 1 to 5 parts; the crosslinking agent 0.2 to 2 parts; the co-crosslinking agent 0.2 to 0.5 parts; the photostabilizer 0.01 to 0.2 parts; and the antioxidant 0.02 to 0.3 parts.

In one embodiment, preferably, the thermoplastic elastomer granules are one of POE or EVA.

In one embodiment, specifically, the crosslinking agent is a mixture of one or more of tert-butylperoxy 2-ethylhexyl carbonate, tert-amylperoxy 2-ethylhexyl carbonate, 2,5-dimethyl-2,5-di(tert-butylperoxy)hexane, tert-butylperoxy-3,5,5-trimethylhexanoate, di-(4-methylbenzoyl) peroxide, dibenzoyl peroxide, 1,1-di(tert-butylperoxy)cyclohexane, tert-butylperoxy 2-ethylhexyl carbonate, butyl 4,4-bis(tert-butyldioxy)valerate, dicumyl peroxide, α,α'-di(tert-butylperoxy) -1,3-diisopropylbenzene, and 1,1-bis(tert-butylperoxy)-3,3,5-trimethylcyclohexane.

In one embodiment, specifically, the co-crosslinking agent is a mixture of one or more of triallyl isocyanurate, triallyl cyanurate, and acrylate co-crosslinking agent; where the acrylate co-crosslinking agent is one of trimethylolpropane triacrylate, ethoxylated trimethylolpropane triacrylate, propylene glycerol triacrylate, and ethoxylated Pentaerythritol tetraacrylate.

In one embodiment, specifically, the photostabilizer is a mixture of one or more of a light screening agent type photostabilizer, a quenching agent type photostabilizer, a free radical scavenger type photostabilizer and a hydroperoxide decomposer type photostabilizer.

In one embodiment, specifically, the antioxidant is a mixture of one or more of hindered phenol antioxidant, aromatic amine antioxidant, phosphite antioxidant, thioether antioxidant, and metal passivator type antioxidant.

In one embodiment, specifically, the step S3 of preparing the pre-prepared material by film casting method into the insulation light-conversion film for the photovoltaic assembly includes: performing material mixing based on a formula and then allowing the mixture to go through screw plasticization and extrusion and then flow out of a mould head and then be rolled by a roller into the insulation light-conversion film for the photovoltaic assembly.

In one embodiment, specifically, the siloxane-coated carbon quantum dots are used because their particle size of 10nm will not affect penetration of the visible light. The light hitting on the surface of the solar cells actually does not decrease and thus the original power generation efficiency of the solar cells will not be negatively affected. The siloxane-coated carbon quantum dots have the following advantages: (1) the coating of siloxane can improve the dispersion effect of the carbon quantum dots; (2) the coating of siloxane can effectively reduce the conductivity of the carbon quantum dots; (3) after siloxane is coated on the carbon quantum dots, silicon oxygen bonds are present in the coating layer and can serve as a silane coupling agent, and thus there is no need to add the silane coupling agent again as done for the conventional adhesive film.

In one embodiment, specifically, the insulation carbon quantum dot light-conversion film can be used as an ultraviolet light-conversion layer which is used together with the ultraviolet cutoff layer to be co-extruded to form the light-conversion encapsulation adhesive film, where the ultraviolet cutoff layer is close to the solar cell side.

In one embodiment, specifically, the weight part ratio of the ultraviolet cutoff layer is: the thermoplastic elastomer granules 100 parts; the ultraviolet absorbent 0.5 to 1 part; the crosslinking agent 0.2 to 2 parts; the co-crosslinking agent 0.2 to 0.5 parts; the silane coupling agent 0.3 to 1 part; the photostabilizer 0.01 to 0.2 parts; the antioxidant 0.02 to 0.3 parts. Preferably, the thermoplastic elastomer granules are one of POE or EVA; the ultraviolet absorbent is a mixture of one or more of 2-hydroxy-4-(octyloxy)benzophenone, ethyl 2-cyano-3,3-diphenylacrylate, P-methoxycinnamate ethylhexyl ester, 2-ethylhexyl trans-4-methoxycinnamate, dimethyl (p-methoxybenzylidene)malonate, N-(2-ethoxyphenyl)-N'-(4-ethylphenyl)-ethlyene diamide, 2-(2'-hydroxy-5 '-tert-octylphenyl)benzotriazole, hexadecyl 3,5-bis-tert-butyl-4-hydroxybenzoate, 2-(4,6-diphenyl-1,3,5-triazin-2-yl)-5-(hexyloxy)phenol, 2-4,6-bis(2,4-dimethylphenyl)-1,3,5-triazin-2-yl-5-(octyloxy)-phenol, 2-(2'-hydroxy-5 '-methylphenyl)benzotriazole, and polysilicone-15. The crosslinking agent is a mixture of one or more of tert-butylperoxy 2-ethylhexyl carbonate, tert-amylperoxy 2-ethylhexyl carbonate, 2,5-dimethyl-2,5-di(tert-butylperoxy)hexane, tert-butylperoxy-3,5,5-trimethylhexanoate, di-(4-methylbenzoyl) peroxide, dibenzoyl peroxide, 1,1-di(tert-butylperoxy)cyclohexane, tert-butylperoxy 2-ethylhexyl carbonate, butyl 4,4-bis(tert-butyldioxy)valerate, dicumyl peroxide, α,α'-di(tert-butylperoxy) -1,3-diisopropylbenzene, and 1,1-bis(tert-butylperoxy)-3,3,5-trimethylcyclohexane. The co-crosslinking agent is a mixture of one or more of triallyl isocyanurate, triallyl cyanurate, and acrylate co-crosslinking agent; where the acrylate co-crosslinking agent is one of trimethylolpropane triacrylate, ethoxylated trimethylolpropane triacrylate, propylene glycerol triacrylate, and ethoxylated pentaerythritol tetraacrylate. The photostabilizer is a mixture of one or more of a light screening agent type photostabilizer, a quenching agent type photostabilizer, a free radical scavenger type photostabilizer and a hydroperoxide decomposer type photostabilizer. The silane coupling agent is any one of KH550, KH560, KH570, KH792 and DL602. The antioxidant is a mixture of one or more of a hindered phenol antioxidant, an aromatic amine antioxidant, a phosphite antioxidant, a thioether antioxidant, and a metal passivator type antioxidant.

In one embodiment, preferably, the ultraviolet cutoff layer has the same type of thermoplastic elastomer granules as the ultraviolet light-conversion layer. The formula of the ultraviolet light-conversion layer is same as that of the above photovoltaic light-conversion film and will not be repeated herein. The two layers are mixed based on the formula and then the mixed material is added to the co-extruder for extrusion, and then goes through respective screw plasticization and gathers at the mould head so as to form the ultraviolet light-conversion adhesive film of double layer.

If no detailed descriptions are made, various raw materials of the present disclosure can be purchased from markets or prepared by conventional method in the prior arts. The EVA model is E282PV manufactured by Hanwha Total; the POE model is 8669 manufactured by DOW Chemical. The transmittance of the ultraviolet light and the visible light is tested by an ultraviolet spectrophotometer (UV-6000); for the light conversion effect, a light emission band is determined by using a fluorescence spectrometer; and the improvement effect of the light conversion on the assembly is determined using a solar cell assembly tester (XJCM-11A+); the insulation performance of the prepared adhesive film is tested using an electrostatic charge tester (6517B); the coating effect of the co-hydrolytic condensation is evaluated by using a transmission electron microscope (JEM-2100) and an X-ray diffractometer (XRD-6000).

Embodiment 1: the siloxane-coated carbon quantum dots are prepared using the following weight parts.
carbon nanotube quantum dots: 1 part
silicon tetraacetate: 1 part
KH550: 10 parts
ammonia water: 1 part
ethanol: 60 parts
water: 10 parts
mechanically stir at the speed of 500rpm for 8 hours and then perform centrifugation at the speed of 5000rpm and then wash and then dry at the temperature of 60°C for later use.

The light-conversion film is prepared using the following weight parts:
EVA: 100 parts
siloxane-coated carbon nanotube quantum dots: 1 part
tert-butylperoxy 2-ethylhexyl carbonate: 1 part
triallyl isocyanurate: 0.3 parts
photostabilizer: 0.05 parts
antioxidant: 0.25 parts
material mixing is performed based on the formula and then the mixed material is added to the extruder and then goes through screw plasticization and is cast into a light-conversion film.

Embodiment 2: the siloxane-coated carbon quantum dots are prepared using the following weight parts:
graphene quantum dots: 5 parts
tetrakis(2-ethylhexyl) ester: 10 parts
KH560: 1 part
acetic acid: 0.1 part
methanol: 90 parts
water: 20 parts
mechanically stir at the speed of 800rpm for 2 hours, and then perform centrifugation at the speed of 10000rpm and then wash and then dry at the temperature of 80°C for later use.

The light-conversion film is prepared using the following weight parts:
POE: 100 parts
siloxane-coated graphene quantum dots: 5 parts
tert-amylperoxy 2-ethylhexyl carbonate: 1.5 parts
triallyl cyanurate: 0.4 parts
photostabilizer: 0.15 parts
antioxidant: 0.25 parts
material mixing is performed based on the formula and then the mixed material is added to the extruder and then goes through screw plasticization and is cast into a light-conversion film.

Embodiment 3: the siloxane-coated carbon quantum dots are prepared using the following weight parts.
nanodiamond quantum dots: 1 part
tetraisopropyl orthosilicate: 5 parts
KH570: 5 parts
formic acid: 0.5 parts
isopropanol: 70 parts
water: 30 parts
mechanically stir at the speed of 600rpm for 4 hours, and then perform centrifugation at the speed of 8000rpm and then wash and then dry at the temperature of 70°C for later use.

The light-conversion film is prepared using the following weight parts:
EVA: 100 parts
siloxane-coated nanodiamond quantum dots: 3 parts
2,5-dimethyl-2,5-di(tert-butylperoxy)hexane: 0.5 parts
trimethylolpropane triacrylate: 0.3 parts
photostabilizer: 0.05 parts
antioxidant: 0.1 parts
material mixing is performed based on the formula and then the mixed material is added to the extruder and then goes through screw plasticization and is cast into a light-conversion film.

Embodiment 4: the siloxane-coated carbon quantum dots are prepared using the following weight parts.
fluorescent carbon particle quantum dots: 2 parts
tetramethyl orthosilicate: 7 parts
KH592: 3 parts
ammonia water: 0.1 parts
propanol: 80 parts
water: 20 parts
mechanically stir at the speed of 700rpm for 6 hours, and then perform centrifugation at the speed of 6000rpm and then wash and then dry at the temperature of 75°C for later use.

The light-conversion film is prepared using the following weight parts:
POE: 100 parts
siloxane-coated fluorescent carbon particle quantum dots: 2 parts
tert-butylperoxy-3,5,5-trimethylhexanoate: 1 part
ethoxylated trimethylolpropane triacrylate: 0.2 parts
photostabilizer: 0.1 parts
antioxidant: 0.05 parts
material mixing is performed based on the formula and then the mixed material is added to the extruder and then goes through screw plasticization and is cast into a light-conversion film.

Embodiment 5: the siloxane-coated carbon quantum dots are prepared using the following weight parts.
carbon nanotube quantum dots: 3 parts
silicon tetraacetate: 4 parts
DL602: 5 parts
ammonium chloride: 0.1 parts
methanol: 50 parts
n- butanol: 20 parts
water: 40 parts
mechanically stir at the speed of 600rpm for 3 hours, and then perform centrifugation at the speed of 7000rpm and then wash and then dry at the temperature of 75°C for later use.

The light-conversion film is prepared using the following weight parts:
POE: 100 parts
siloxane-coated carbon nanotube quantum dots: 4 parts
di-(4-methylbenzoyl) peroxide: 2 parts
propylene glycerol triacrylate: 0.2 parts
photostabilizer: 0.2 parts
antioxidant: 0.02 parts
material mixing is performed based on the formula and then the mixed material is added to the extruder and then goes through screw plasticization and is cast into a light-conversion film.

Embodiment 6: the siloxane-coated carbon quantum dots are prepared using the following weight parts.
carbon nanotube quantum dots: 4 parts
silicon tetraacetate: 8 parts
KH570: 4 parts
hydrochloric acid: 0.3 parts
ethanol: 60 parts
n- butanol: 10 parts
water: 10 parts
mechanically stir at the speed of 800rpm for 3 hours, and then perform centrifugation at the speed of 7000rpm and then wash and then dry at the temperature of 75°C for later use.

The ultraviolet light-conversion layer is prepared using the following weight parts:
EVA: 100 parts
siloxane-coated carbon nanotube quantum dots: 2 parts
dibenzoyl peroxide: 0.2 parts
ethoxylated Pentaerythritol tetraacrylate: 0.5 parts
photostabilizer: 0.01 parts
antioxidant: 0.3 parts

The ultraviolet cutoff layer is prepared using the following weight parts.
EVA: 100 parts
2-hydroxy-4-(octyloxy)benzophenone: 1 part
tert-butylperoxy 2-ethylhexyl carbonate: 1 parts
triallyl isocyanurate: 0.5 parts
KH570: 0.3 parts
photostabilizer: 0.01 parts
antioxidant: 0.02 parts

The two layers are mixed based on the formula and then the mixed material is added to the co-extruder for extrusion, and then goes through respective screw plasticization and gathers at the mould head so as to form the ultraviolet light-conversion adhesive film of double layer.

### Comparative embodiment 1

The light-conversion film is prepared using the following weight parts:
EVA: 100 parts
siloxane-coated carbon nanotube quantum dots: 10 parts
tert-butylperoxy 2-ethylhexyl carbonate: 1 part
triallyl isocyanurate: 0.3 parts
photostabilizer: 0.05 parts
antioxidant: 0.25 parts
material mixing is performed based on the formula and then the mixed material is added to the extruder and then goes through screw plasticization and is cast into a light-conversion film.

### Comparative embodiment 2

The light-conversion film is prepared using the following weight parts:
EVA: 100 parts
carbon nanotube quantum dots: 1 part
tert-butylperoxy 2-ethylhexyl carbonate: 1 part
triallyl isocyanurate: 0.3 parts
photostabilizer: 0.05 parts
antioxidant: 0.25 parts
material mixing is performed based on the formula and then the mixed material is added to the extruder and then goes through screw plasticization and is cast into a light-conversion film.

### Comparative embodiment 3

Pure EVA goes through screw plasticization and is cast into a light-conversion film.

### Comparative embodiment 4

The ultraviolet cutoff layer is prepared using the following weight parts:
EVA: 100 parts
2-hydroxy-4-(octyloxy)benzophenone: 1 part
tert-butylperoxy 2-ethylhexyl carbonate: 1 part
triallyl isocyanurate: 0.5 parts
KH570: 0.3 parts
photostabilizer: 0.01 parts
antioxidant: 0.02 parts

With the pure EVA replacing the ultraviolet light-conversion layer, the mixed material is added into the co-extruder for extrusion and goes through respective screw plasticization and gathers in the mould head so as to form the ultraviolet light-conversion adhesive film of double layer.

The adhesive films prepared in the embodiments 1 to 6 and the comparative embodiments 1 to 4 are used to prepare a photovoltaic assembly in the following preparation method:

The photovoltaic assemblies specifically include an upper-layer glass, an upper-layer light-conversion adhesive film, a heterojunction cell, a lower-layer light-conversion adhesive film and a lower-layer glass, and all of them are double-glass assemblies. The upper-layer light-conversion adhesive film and the lower-layer light-conversion adhesive film both are the light-conversion films of the present disclosure.

**Table 1 test performances of the photovoltaic assemblies in the embodiments 1 to 6 and the comparative embodiments 1 to 4**

| | Volume resistivity (Ω·m) | Ultraviolet light transmittance (%) | Visible light transmittance (%) | Initial assembly power (W) | After-UV300kwh assembly power (W) |
|---|---|---|---|---|---|
| Embodiment 1 | 7.5×10¹¹ | 8.6 | 91.5 | 342.77 | 334.71 |
| Embodiment 2 | 9.5×10¹⁰ | 6.5 | 90.8 | 343.52 | 336.85 |
| Embodiment 3 | 2.5×10¹¹ | 7.3 | 91.1 | 343.09 | 335.91 |
| Embodiment 4 | 3.7×10¹¹ | 7.9 | 91.3 | 342.98 | 335.71 |
| Embodiment 5 | 1.1×10¹¹ | 7.2 | 90.9 | 343.14 | 334.98 |
| Embodiment 6 | 3.2×10¹¹ | 4.2 | 91.2 | 339.87 | 334.9 |
| Comparative embodiment 1 | 2.4×10⁷ | 5.9 | 90.2 | 341.22 | 325.85 |
| Comparative embodiment 2 | 9.8×10⁹ | 8.9 | 91.0 | 337.57 | 328.64 |
| Comparative embodiment 3 | 3.5×10¹³ | 13.4 | 91.1 | 336.54 | 303.47 |
| Comparative embodiment 4 | 4.1×10¹² | 5.3 | 90.8 | 337.21 | 332.57 |

The experimental results of the Table show that the coating of the co-hydrolytic condensation can effectively reduce the conductivity of the carbon quantum dots and the use of the siloxane-coated carbon quantum dots can effectively increase the power generation efficiency of the photovoltaic assembly, reducing the power attenuation of the assembly.

Compared with the embodiment 1, in the comparative embodiment 1, excess siloxane-coated carbon nanotube quantum dots are added. Since excess dosage will result in agglomeration which will then bring damage to the performance of the adhesive film. Therefore, the power attenuation will worsen. Furthermore, although the siloxane-coated carbon nanotube quantum dots can reduce the conductivity of the carbon quantum dots, the insulation coating can only weaken the conductivity of the carbon material to some extent and cannot achieve complete insulation. When the system-coated carbon quantum dots are excessively high in content, the adhesive film will suffer the phenomenon of decreasing insulation performance. Further, compared with the pure EVA adhesive film of the comparative embodiment 3, the agglomeration resulting from excess dosage enables the comparative embodiments with addition of siloxane-coated carbon nanotube quantum dots to suffer a lower ultraviolet transmittance.

Compared with the embodiment 1, in the comparative embodiment 2, the siloxane-coated carbon nanotube quantum dots are changed into the carbon nanotube quantum dots. Because the carbon nanotube quantum dots have a high conductivity, noticeable increase of the resistivity occurs while the anti-aging performance of the photovoltaic assembly drops.

The comparative embodiment 3 involves pure EVA adhesive film and its ultraviolet light transmittance is far higher than that of other embodiments and comparative embodiments, but it has poorer anti-aging performance and is not applicable to the ultraviolet light-conversion film.

Compared with the embodiment 6, in the comparative embodiment 4, the ultraviolet light-conversion layer in the embodiment 6 is replaced with a pure EVA layer. Despite increase of the volume resistivity, the ultraviolet light transmittance increases.

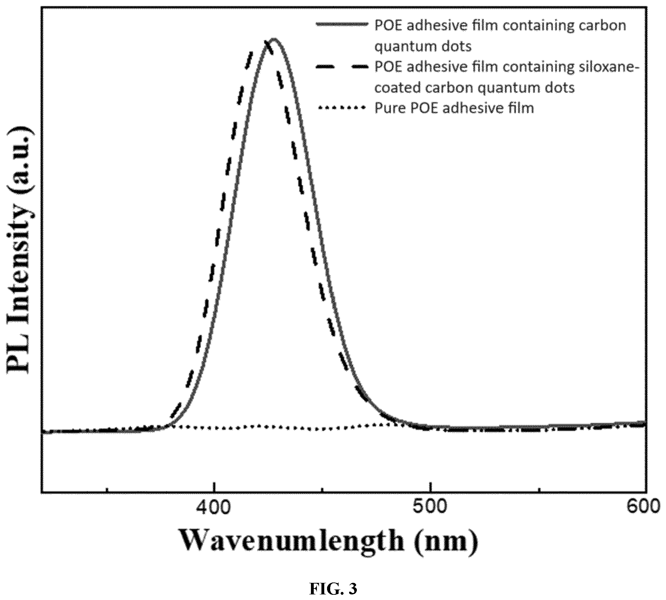

As shown in FIG. 3, the POE adhesive film containing the siloxane-coated carbon quantum dots suffers a small displacement relative to the POE adhesive film containing the carbon quantum dots because the coating of siloxane can have effect on the wave band of the light received by the carbon quantum dots and the converted wave band after the fluorescent effect is generated differs slightly. But due to small offset, only a tiny effect on the light conversion can be generated. Thus, the light conversion effect is ensured while the insulation performance is guaranteed.

In conclusion, in the insulation light-conversion film for a photovoltaic assembly and a preparation method thereof in the present disclosure, by better dispersing the insulation-modified siloxane-coated carbon quantum dots in the resin substrate, the light-conversion rate of the adhesive film for the ultraviolet light is effectively increased, which increases the power generation efficiency of the assembly and reduces the attenuation of the power generation efficiency of the aged assembly. The preparation process is simple, and environment-friendly and can be applied to the existing photovoltaic production process.

## Claims

1. An insulation light-conversion film for a photovoltaic assembly, comprising:
thermoplastic elastomer granules, siloxane-coated carbon quantum dots, a crosslinking agent, a co-crosslinking agent, a photostabilizer, and an antioxidant, wherein the weight ratio of the above substances is as follows:
thermoplastic elastomer granules: 100 parts;
siloxane-coated carbon quantum dots: 1 to 5 parts;
crosslinking agent: 0.2 to 2 parts;
co-crosslinking agent: 0.2 to 0.5 parts;
photostabilizer: 0.01 to 0.2 parts; and
antioxidant: 0.02 to 0.3 parts.

2. The insulation light-conversion film according to claim 1, wherein the siloxane-coated carbon quantum dots comprise:
silicate ester, a silane coupling agent, a catalyst, an alcohol, water, and carbon quantum dots, wherein the weight ratio of the above substances is as follows:
carbon quantum dots: 1 to 5 parts;
silicate ester: 1 to 10 parts;
silane coupling agent: 1 to 10 parts;
catalyst: 0.1 to 1 part;
alcohol: 60 to 90 parts; and
water: 10 to 40 parts.

3. The insulation light-conversion film according to claim 2, wherein the carbon quantum dots are one of or a mixture of carbon nanotube quantum dots, graphene quantum dots, nano-diamond quantum dots, and fluorescent carbon particle quantum dots;and
the silicate ester is any one of silicon tetraacetate, tetrakis(2-ethylhexyl) ester, tetraisopropyl orthosilicate, and tetramethyl orthosilicate;and
the silane coupling agent is any one of KH550, KH560, KH570, KH792, and DL602; and
the silicate ester is any one of silicon tetraacetate, tetrakis(2-ethylhexyl) ester, tetraisopropyl orthosilicate, and tetramethyl orthosilicate;and
the alcohol is one of or a mixture of methanol, ethanol, propanol, isopropanol, and n-butanol; and
the thermoplastic elastomer granules are one of POE or EVA.

4. A double-layer light-conversion adhesive film, comprising:
the insulation light-conversion film for the photovoltaic assembly according to any of claims 1-3, and an ultraviolet cutoff-layer adhesive film.

5. A photovoltaic assembly, comprising:
the insulation light-conversion film for the photovoltaic assembly according to any of claims 1-3 as a single-layer light-conversion adhesive film.

6. A photovoltaic assembly, comprising:
the double-layer light-conversion adhesive film according to claim 4.

7. A preparation method of an insulation light-conversion film for a photovoltaic assembly, comprising the following steps:
at step S1, by co-hydrolytic condensation of silicate ester and a silane coupling agent, performing insulation coating on carbon quantum dots to obtain siloxane-coated carbon quantum dots;
at step S2, mixing the siloxane-coated carbon quantum dots, thermoplastic elastomer granules and aids uniformly to obtain a pre-prepared material;
at step S3, preparing the pre-prepared material by film casting method into an insulation light-conversion film for the photovoltaic assembly; wherein,
the co-hydrolytic condensation comprises the following steps:
dissolving silicate ester and the silane coupling agent in an aqueous solution of an alcohol, and then adding carbon quantum dots and a catalyst and then stirring for 2 to 8 hours;
performing centrifugation, washing and drying to obtain the siloxane-coated carbon quantum dots for later use;
the thermoplastic elastomer granules are one of POE or EVA; and
the aids comprise a crosslinking agent, a co-crssolinking agent, a photostabilizer, and an antioxidant.

8. The preparation method according to claim 7, wherein,
the carbon quantum dots are one of or a mixture of carbon nanotube quantum dots, graphene quantum dots, nano-diamond quantum dots, and fluorescent carbon particle quantum dots; and
the silicate ester is any one of silicon tetraacetate, tetrakis(2-ethylhexyl) ester, tetraisopropyl orthosilicate, and tetramethyl orthosilicate; and
the silane coupling agent is any one of KH550, KH560, KH570, KH792, and DL602; and the alcohol is one of or a mixture of methanol, ethanol, propanol, isopropanol, and n-butanol.

9. The preparation method according to claim 7, wherein
the weight ratio of silicate ester, the silane coupling agent, the catalyst, the alcohol, water, and the carbon quantum dots is as follows:
carbon quantum dots: 1 to 5 parts;
silicate ester: 1 to 10 parts;
silane coupling agent: 1 to 10 parts;
catalyst: 0.1 to 1 part;
alcohol: 60 to 90 parts; and
water: 10 to 40 parts;and
the weight ratio of the thermoplastic elastomer granules, the siloxane-coated carbon quantum dots, the crosslinking agent, the co-crosslinking agent, the photostabilizer, and the antioxidant is as follows:
thermoplastic elastomer granules: 100 parts;
siloxane-coated carbon quantum dots: 1 to 5 parts;
crosslinking agent: 0.2 to 2 parts;
co-crosslinking agent: 0.2 to 0.5 parts;
photostabilizer: 0.01 to 0.2 parts; and
antioxidant: 0.02 to 0.3 parts.

10. The preparation method according to claim 7, wherein the step S3 of preparing the pre-prepared material by film casting method into the insulation light-conversion film for the photovoltaic assembly comprises:
performing material mixing based on a formula and then allowing the mixture to go through screw plasticization and extrusion and then flow out of a mould head and then be rolled by a roller into the insulation light-conversion film for the photovoltaic assembly.

## Patentansprüche

1. Eine Isolations-Lichtumwandlungsfolie für eine Photovoltaikanordnung, umfassend:
thermoplastische Elastomer-Granulate, siloxanbeschichtete Kohlenstoff-Quantenpunkte, einen Vernetzer, einen Co-Vernetzer, einen Photostabilisator und ein Antioxidans, wobei das Gewichtsverhältnis der genannten Substanzen wie folgt ist:
thermoplastische Elastomer-Granulate: 100 Teile;
siloxanbeschichtete Kohlenstoff-Quantenpunkte: 1 bis 5 Teile;
Vernetzer: 0,2 bis 2 Teile;
Co-Vernetzer: 0,2 bis 0,5 Teile;
Photostabilisator: 0,01 bis 0,2 Teile; und
Antioxidans: 0,02 bis 0,3 Teile.

2. Die Isolations-Lichtumwandlungsfolie nach Anspruch 1, wobei die siloxanbeschichteten Kohlenstoff-Quantenpunkte umfassen:
einen Silikatester, ein Silankopplungsmittel, einen Katalysator, einen Alkohol, Wasser und Kohlenstoff-Quantenpunkte, wobei das Gewichtsverhältnis der genannten Substanzen wie folgt ist:
Kohlenstoff-Quantenpunkte: 1 bis 5 Teile;
Silikatester: 1 bis 10 Teile;
Silankopplungsmittel: 1 bis 10 Teile;
Katalysator: 0,1 bis 1 Teil;
Alkohol: 60 bis 90 Teile; und
Wasser: 10 bis 40 Teile.

3. Die Isolations-Lichtumwandlungsfolie nach Anspruch 2, wobei
die Kohlenstoff-Quantenpunkte ausgewählt sind aus Kohlenstoff-Nanoröhren-Quantenpunkten, Graphen-Quantenpunkten, Nano-Diamant-Quantenpunkten und fluoreszierenden Kohlenstoffteilchen-Quantenpunkten oder einer Mischung derselben; und
der Silikatester ausgewählt ist aus Siliciumtetraacetat, Tetrakis(2-ethylhexyl)-Ester, Tetraisopropylorthosilikat und Tetramethylorthosilikat; und
das Silankopplungsmittel ausgewählt ist aus KH550, KH560, KH570, KH792 und DL602; und
der Alkohol ausgewählt ist aus Methanol, Ethanol, Propanol, Isopropanol und n-Butanol oder einer Mischung derselben; und
die thermoplastischen Elastomer-Granulate ausgewählt sind aus POE oder EVA.

4. Eine doppelschichtige Lichtumwandlungs-Klebefolie, umfassend:
die Isolations-Lichtumwandlungsfolie für die Photovoltaikanordnung nach einem der Ansprüche 1-3 und eine UV-Abschirm-Klebefolie.

5. Eine Photovoltaikanordnung, umfassend:
die Isolations-Lichtumwandlungsfolie für die Photovoltaikanordnung nach einem der Ansprüche 1-3 als einschichtige Lichtumwandlungs-Klebefolie.

6. Eine Photovoltaikanordnung, umfassend:
die doppelschichtige Lichtumwandlungs-Klebefolie nach Anspruch 4.

7. Ein Herstellungsverfahren für eine Isolations-Lichtumwandlungsfolie für eine Photovoltaikanordnung, umfassend folgende Schritte:
Schritt S1, durch ko-hydrolytische Kondensation von Silikatester und Silankopplungsmittel eine Isolationsbeschichtung der Kohlenstoff-Quantenpunkte durchführen, um siloxanbeschichtete Kohlenstoff-Quantenpunkte zu erhalten;
Schritt S2, die siloxanbeschichteten Kohlenstoff-Quantenpunkte, thermoplastische Elastomer-Granulate und die Hilfsstoffe gleichmäßig mischen, um einen Vorbereitungsstoff zu erhalten;
Schritt S3, den Vorbereitungsstoff durch Foliengießverfahren zu einer Isolations-Lichtumwandlungsfolie für die Photovoltaikanordnung verarbeiten; wobei,
das Ko-hydrolytische Kondensation folgende Unterschritte umfasst:
Dissolution von Silikatester und Silankopplungsmittel in einer alkoholischen wässrigen Lösung, dann Zugabe von Kohlenstoff-Quantenpunkten und Katalysator und Rühren für 2 bis 8 Stunden;
Zentrifugation, Waschen und Trocknen durchführen, um die siloxanbeschichteten Kohlenstoff-Quantenpunkte für die spätere Verwendung zu erhalten;
die thermoplastischen Elastomer-Granulate sind ausgewählt aus POE oder EVA; und
die Hilfsstoffe umfassen einen Vernetzer, einen Co-Vernetzer, einen Photostabilisator und ein Antioxidans.

8. Das Herstellungsverfahren nach Anspruch 7, wobei,
die Kohlenstoff-Quantenpunkte ausgewählt sind aus Kohlenstoff-Nanoröhren-Quantenpunkten, Graphen-Quantenpunkten, Nano-Diamant-Quantenpunkten und fluoreszierenden Kohlenstoffteilchen-Quantenpunkten oder einer Mischung derselben; und
der Silikatester ausgewählt ist aus Siliciumtetraacetat, Tetrakis(2-ethylhexyl)-Ester, Tetraisopropylorthosilikat und Tetramethylorthosilikat; und
das Silankopplungsmittel ausgewählt ist aus KH550, KH560, KH570, KH792 und DL602; und
der Alkohol ausgewählt ist aus Methanol, Ethanol, Propanol, Isopropanol und n-Butanol oder einer Mischung derselben.

9. Das Herstellungsverfahren nach Anspruch 7, wobei
das Gewichtsverhältnis von Silikatester, Silankopplungsmittel, Katalysator, Alkohol, Wasser und Kohlenstoff-Quantenpunkten wie folgt ist:
Kohlenstoff-Quantenpunkte: 1 bis 5 Teile;
Silikatester: 1 bis 10 Teile;
Silankopplungsmittel: 1 bis 10 Teile;
Katalysator: 0,1 bis 1 Teil;
Alkohol: 60 bis 90 Teile; und
Wasser: 10 bis 40 Teile; und
das Gewichtsverhältnis von thermoplastischen Elastomer-Granulaten, siloxanbeschichteten Kohlenstoff-Quantenpunkten, Vernetzer, Co-Vernetzer, Photostabilisator und Antioxidans wie folgt ist:
thermoplastische Elastomer-Granulate: 100 Teile;
siloxanbeschichtete Kohlenstoff-Quantenpunkte: 1 bis 5 Teile;
Vernetzer: 0,2 bis 2 Teile;
Co-Vernetzer: 0,2 bis 0,5 Teile;
Photostabilisator: 0,01 bis 0,2 Teile; und
Antioxidans: 0,02 bis 0,3 Teile.

10. Das Herstellungsverfahren nach Anspruch 7, wobei der Schritt S3 des Verarbeitens des Vorbereitungsstoffs durch Foliengießverfahren in die Isolations-Lichtumwandlungsfolie für die Photovoltaikanordnung umfasst:
Durchführen der Materialmischung basierend auf einer Rezeptur und anschließend das Gemisch einer Schraubenplastifizierung und Extrusion unterziehen und dann aus einem Formkopf ausströmen lassen und anschließend von einer Walze zu der Isolations-Lichtumwandlungsfolie für die Photovoltaikanordnung gewalzt werden.

## Revendications

1. Film isolant de conversion lumineuse pour un assemblage photovoltaïque, comprenant :
granules d'élastomère thermoplastique, points quantiques de carbone revêtus de siloxane, un agent de réticulation, un co-agent de réticulation, un photostabilisant et un antioxydant, dans lequel le rapport pondéral desdites substances est le suivant :
granules d'élastomère thermoplastique : 100 parties ;
points quantiques de carbone revêtus de siloxane : 1 à 5 parties ;
agent de réticulation : 0,2 à 2 parties ;
co-agent de réticulation : 0,2 à 0,5 parties ;
photostabilisant : 0,01 à 0,2 parties ; et
antioxydant : 0,02 à 0,3 parties.

2. Le film isolant de conversion lumineuse selon la revendication 1, dans lequel les points quantiques de carbone revêtus de siloxane comprennent :
un ester de silicate, un agent de couplage silanique, un catalyseur, un alcool, de l'eau et des points quantiques de carbone, dans lequel le rapport pondéral desdites substances est le suivant :
points quantiques de carbone : 1 à 5 parties ;
ester de silicate : 1 à 10 parties ;
agent de couplage silanique : 1 à 10 parties ;
catalyseur : 0,1 à 1 partie ;
alcool : 60 à 90 parties ; et
eau : 10 à 40 parties.

3. Le film isolant de conversion lumineuse selon la revendication 2, dans lequel
les points quantiques de carbone sont choisis parmi points quantiques de nanotubes de carbone, points quantiques de graphène, points quantiques de nanodiamant et points quantiques de particules de carbone fluorescentes ou un mélange de ceux-ci ; et
l'ester de silicate est choisi parmi tétraacétate de silicium, tétrakis(2-éthylhexyl) ester, orthosilicate de tétraisopropyle et orthosilicate de tétraméthyle ; et
l'agent de couplage silanique est choisi parmi KH550, KH560, KH570, KH792 et DL602 ; et
l'alcool est choisi parmi méthanol, éthanol, propanol, isopropanol et n-butanol ou un mélange de ceux-ci ; et
les granules d'élastomère thermoplastique sont choisis parmi POE ou EVA.

4. Un film adhésif double couche de conversion lumineuse, comprenant :
le film isolant de conversion lumineuse pour l'assemblage photovoltaïque selon l'une quelconque des revendications 1-3 et un film adhésif à couche de coupure UV.

5. Un assemblage photovoltaïque, comprenant :
le film isolant de conversion lumineuse pour l'assemblage photovoltaïque selon l'une quelconque des revendications 1-3 en tant que film adhésif de conversion lumineuse monocouche.

6. Un assemblage photovoltaïque, comprenant :
le film adhésif double couche de conversion lumineuse selon la revendication 4.

7. Un procédé de préparation d'un film isolant de conversion lumineuse pour un assemblage photovoltaïque, comprenant les étapes suivantes :
à l'étape S1, par condensation co-hydrolytique d'un ester de silicate et d'un agent de couplage silanique, effectuer un revêtement isolant sur des points quantiques de carbone pour obtenir des points quantiques de carbone revêtus de siloxane ;
à l'étape S2, mélanger uniformément les points quantiques de carbone revêtus de siloxane, les granules d'élastomère thermoplastique et les auxiliaires pour obtenir un matériau préliminaire ;
à l'étape S3, transformer le matériau préliminaire par procédé de coulage de film en un film isolant de conversion lumineuse pour l'assemblage photovoltaïque ;
dans lequel,
la condensation co-hydrolytique comprend les sous-étapes suivantes :
dissolution d'un ester de silicate et de l'agent de couplage silanique dans une solution aqueuse alcoolique, puis ajout de points quantiques de carbone et d'un catalyseur et agitation pendant 2 à 8 heures ;
réalisation d'une centrifugation, d'un lavage et d'un séchage pour obtenir les points quantiques de carbone revêtus de siloxane pour usage ultérieur ;
les granules d'élastomère thermoplastique sont choisis parmi POE ou EVA ; et
les auxiliaires comprennent un agent de réticulation, un co-agent de réticulation, un photostabilisant et un antioxydant.

8. Le procédé de préparation selon la revendication 7, dans lequel,
les points quantiques de carbone sont choisis parmi points quantiques de nanotubes de carbone, points quantiques de graphène, points quantiques de nanodiamant et points quantiques de particules de carbone fluorescentes ou un mélange de ceux-ci ; et
l'ester de silicate est choisi parmi tétraacétate de silicium, tétrakis(2-éthylhexyl) ester, orthosilicate de tétraisopropyle et orthosilicate de tétraméthyle ; et
l'agent de couplage silanique est choisi parmi KH550, KH560, KH570, KH792 et DL602 ; et
l'alcool est choisi parmi méthanol, éthanol, propanol, isopropanol et n-butanol ou un mélange de ceux-ci.

9. Le procédé de préparation selon la revendication 7, dans lequel
le rapport pondéral de l'ester de silicate, de l'agent de couplage silanique, du catalyseur, de l'alcool, de l'eau et des points quantiques de carbone est le suivant :
points quantiques de carbone : 1 à 5 parties ;
ester de silicate : 1 à 10 parties ;
agent de couplage silanique : 1 à 10 parties ;
catalyseur : 0,1 à 1 partie ;
alcool : 60 à 90 parties ; et
eau : 10 à 40 parties ; et
le rapport pondéral des granules d'élastomère thermoplastique, des points quantiques de carbone revêtus de siloxane, de l'agent de réticulation, du co-agent de réticulation, du photostabilisant et de l'antioxydant est le suivant :
granules d'élastomère thermoplastique : 100 parties ;
points quantiques de carbone revêtus de siloxane : 1 à 5 parties ;
agent de réticulation : 0,2 à 2 parties ;
co-agent de réticulation : 0,2 à 0,5 parties ;
photostabilisant : 0,01 à 0,2 parties ; et
antioxydant : 0,02 à 0,3 parties.

10. Le procédé de préparation selon la revendication 7, dans lequel l'étape S3 de transformation du matériau préliminaire par procédé de coulage de film en film isolant de conversion lumineuse pour l'assemblage photovoltaïque comprend :
réaliser le mélange des matériaux selon une formule, puis soumettre le mélange à une plastification par vis et extrusion, puis laisser s'écouler par une tête de moule et enfin enrouler par un rouleau pour former le film isolant de conversion lumineuse pour l'assemblage photovoltaïque.
